# EUROPEAN PATENT APPLICATION

(11) **EP 4 752 632 A2**
(43) Date of publication of application: **03.06.2026**
(21) Application number: 26167024.4
(22) Date of filing: 24.03.2026
(51) Int. Cl.: G03F 7/00

(54) **APPARATUS OPERATING MODE**

(71) Applicant: ASML Netherlands B.V., 5500 AH Veldhoven (NL)
(72) Inventor: BROUWER, Cornelis, Melchior, 5500 AH, Veldhoven (NL)
(74) Representative: ASML Netherlands B.V.

(57) **Abstract**

Disclosed is a method for operating an exposure apparatus comprising: initiating a transition mode responsive to an instruction for the exposure apparatus to transition from a low energy mode to a production mode, the transition mode comprising; measuring at least one operating parameter; and operating the exposure apparatus while performing a compensation procedure based on the at least one operating parameter, wherein the compensation procedure compensates for a reduced performance of the exposure apparatus associated with the low energy mode.

## Description

### FIELD

The present invention relates to methods and apparatus usable, for example, in the manufacture of devices by lithographic techniques.

### BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In device manufacturing methods using lithographic apparatus, an important factor is the yield, i.e. the percentage of correctly manufactured devices, is the accuracy within which layers are printed in relation to layers that have previously been formed. This is known as overlay and the overlay error budget will often be 10nm or less. To achieve such accuracy, the substrate must be aligned to the reticle pattern to be transferred with great accuracy.

The process in which features with dimensions smaller than the classical resolution limit of a lithographic projection apparatus are printed, is commonly known as low-k, lithography, according to the resolution formula CD=k1xλ/NA, where λ is the wavelength of radiation employed (currently in most cases 248 nm or 193 nm), NA is the numerical aperture of projection system in the lithographic projection apparatus, CD is the "critical dimension"-generally the smallest feature size printed-and kl is an empirical resolution factor. In general, the smaller kl the more difficult it becomes to reproduce a pattern on the substrate that resembles the shape and dimensions planned by a designer in order to achieve particular electrical functionality and performance. To overcome these difficulties, sophisticated fine-tuning steps are applied to the lithographic projection apparatus, the design layout, or the patterning device. These include, for example, but not limited to, optimization of NA and optical coherence settings, customized illumination schemes, use of phase shifting patterning devices, optical proximity correction (OPC, sometimes also referred to as "optical and process correction") in the design layout, or other methods generally defined as "resolution enhancement techniques" (RET). The term "projection system" as used herein should be broadly interpreted as encompassing various types of optical systems, including refractive optics, reflective optics, apertures and catadioptric optics, for example. The term "projection system" or "projection optics" may also include components operating according to any of these design types for directing, shaping or controlling the projection beam of radiation, collectively or singularly. The term "projection system" may include any optical component in the lithographic projection apparatus, no matter where the optical component is located on an optical path of the lithographic projection apparatus. The projection system may include optical components for shaping, adjusting and/or projecting radiation from the source before the radiation passes the patterning device, and/or optical components for shaping, adjusting and/or projecting the radiation after the radiation passes the patterning device. The projection system generally excludes the source and the patterning device.

When not processing substrates, a lithographic apparatus may enter a low energy state, or mode, to save energy and/or materials. When the lithographic apparatus is required to begin substrate processing again, there is a period of time where the lithographic apparatus is not able to process substrates while the system reconditions from the low energy mode, leading to a production output penalty. It is thus desirable to have methods for mitigating the production output penalty associated with transitioning a lithography apparatus from a low energy mode to a production mode.

### SUMMARY OF THE INVENTION

The invention in a first aspect provides a method for operating an exposure apparatus comprising: initiating a transition mode responsive to an instruction for the exposure apparatus to transition from a low energy mode to a production mode, the transition mode comprising; measuring at least one operating parameter; and operating the exposure apparatus while performing a compensation procedure based on the at least one operating parameter, wherein the compensation procedure compensates for a reduced performance of the exposure apparatus associated with the low energy mode.

Further features of various aspects of the present disclosure are described in detail below with reference to the accompanying drawings. It is noted that the present disclosure is not limited to the specific aspects described herein. Such aspects are presented herein for illustrative purposes only. Additional aspects will be apparent to those skilled in the relevant art(s) based on the teachings contained herein.

### BRIEF DESCRIPTION OF THE DRAWINGS

Embodiments of the invention will now be described, by way of example only, with reference to the accompanying drawings, in which:
Figure 1 depicts a lithographic apparatus;
Figure 2 illustrates schematically measurement and exposure processes in the apparatus of Figure 1; and
Figure 3 depicts a method of operating an exposure apparatus in accordance with some embodiments.

### DETAILED DESCRIPTION OF EMBODIMENTS

Before describing embodiments of the invention in detail, it is instructive to present an example environment in which embodiments of the present invention may be implemented.

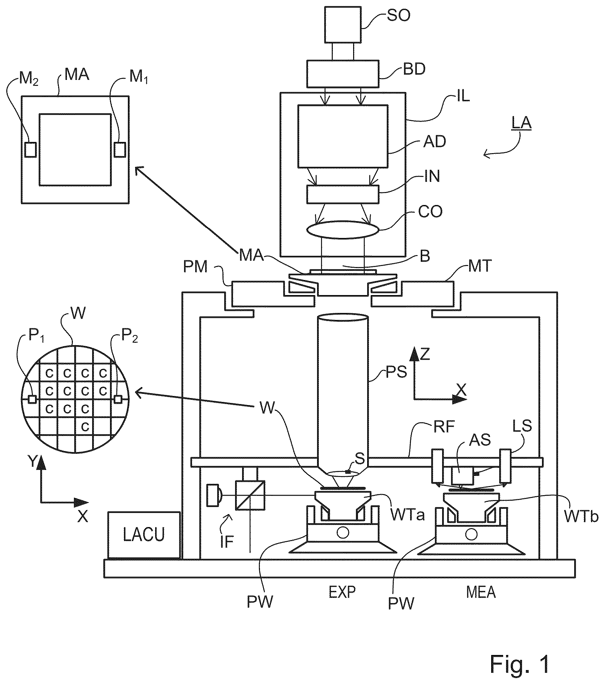

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support MT holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator may be adjusted. In addition, the illuminator IL may comprise various other components, such as an integrator IN and a condenser CO. The illuminator IL may be used to condition the radiation beam B, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

The lithographic apparatus may comprise an aberration sensor for the verification of an aberration fingerprint of the projection system PS. In an embodiment such an aberration fingerprint, i.e. aberrations per field point of the projection system PS, may be determined using a such wavefront aberration sensor. A wavefront aberration sensor of a known type, for instance such as described in US2002/0001088 may be used. Such a wavefront aberration sensor may be based on the principle of shearing interferometry and comprises a source module and a sensor module. The source module may comprise a patterned layer of chromium that is placed in the object plane (i.e. where during production the pattern of the patterning means is) of the projection system PS and has additional optics provided above the chromium layer. The combination provides a wavefront of radiation to the entire pupil of the projection system PS. The sensor module may comprise a patterned layer of chromium that is placed in the image plane of the projection system (i.e. where during production the substrate W is) and a camera that is placed some distance behind said layer of chromium. The patterned layer of chromium on the sensor module diffracts radiation into several diffraction orders that interfere with each other giving rise to an interferogram. The interferogram is measured by the camera. The aberrations in the projection lens can be determined by software based upon the measured interferogram. The wavefront aberration sensor may be configured to transfer information with respect to the aberration fingerprint towards the control unit.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

The lithographic apparatus control unit LACU which controls all the movements and measurements of various actuators and sensors to receive substrates W and reticles MA and to implement the patterning operations. Lithographic apparatus control unit LACU also includes signal processing and data processing capacity to implement desired calculations relevant to the operation of the apparatus, e.g., based on *inter alia* level sensor LS data, alignment sensor AS data and feedback metrology data (e.g., one or more of *inter alia* overlay, focus, dose, critical dimension data). In practice, control unit LACU may be realized as a system of many sub-units, each handling the real-time data acquisition, processing and control of a subsystem or component within the apparatus.

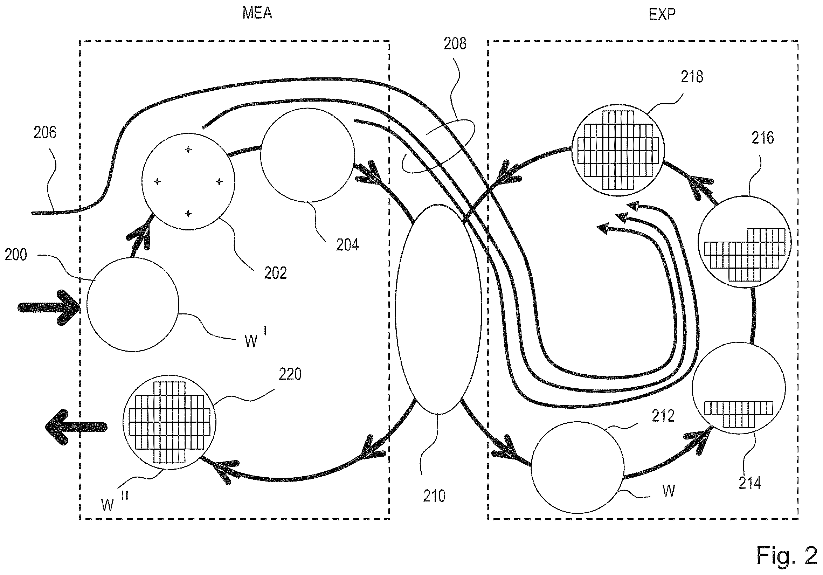

Figure 2 illustrates the steps to expose target portions (e.g. dies) on a substrate W in the dual stage apparatus of Figure 1. On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. These processing steps progressively introduce distortions in the substrate that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 202, alignment measurements using the substrate marks P1 etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a "wafer grid", which maps very accurately the distribution of marks across the substrate, including any distortion relative to a nominal rectangular grid.

At step 204, a map of wafer height (Z) against X-Y position is measured also using the level sensor LS. Conventionally, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure station EXP. The measurements of alignment data for example comprise X and Y positions of alignment targets formed in a fixed or nominally fixed relationship to the product patterns that are the product of the lithographic process. These alignment data, taken just before exposure, are used to generate an alignment model with parameters that fit the alignment model to the data. These parameters and the alignment model will be used during the exposure operation to correct positions of patterns applied in the current lithographic step. The model in use interpolates positional deviations between the measured positions. A conventional alignment model might comprise four, five or six parameters, together defining translation, rotation and scaling of the 'ideal' grid, in different dimensions. Advanced models are known that use more parameters.

At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

In the flow of Figure 2, on the measurement side, the wafer alignment data measured at step 202 and the wafer height/leveling data measured at step 204 are both measured with respect to a reference arrangement or fiducial. For example, the fiducial may comprise a fiducial sensor on a wafer stage or chuck (more generally a substrate support) and a plurality of reference structures (e.g., a set of marks), comprising respectively one or more reference structures or marks on the substrate support and one or more reference structures or marks on the reticle and/or reticle stage.

On the measurement side, an alignment sensor and/or leveling sensor illuminates the one or more substrate support marks on the fiducial surface during alignment and leveling. As a result, the aligned wafer position in the wafer plane is described with respect to the fiducial by the wafer alignment data (measurements of alignment structures or marks on the wafer) and/or the wafer position in the direction perpendicular to the wafer plane is described with respect to the fiducial by the leveling data. Typically more than one mark is measured on the fiducial, enabling the shape, and therefore any drift in this shape over time, of the fiducial surface to be characterized or modeled. This may be done using alignment modeling techniques, e.g., to measure and model an aligned position deviation (APD) with respect to nominal or expected positions of each mark assuming a perfectly flat surface.

On the exposure side, the reticle alignment step of step 212 aligns the reticle with respect to the fiducial. This may be achieved by using the fiducial sensor on the fiducial to measure illumination (e.g., from the exposure source) via one or more reference structures or marks on the reticle and/or reticle stage. In addition to reticle stage positioning, other corrections may be performed at the expose side, e.g., lens corrections based on lens aberration measurements (wavefront measurements) which may also be performed by the fiducial sensor.

In performing these measurement steps 202, 204, 212, each with respect to the fiducial, the position of the reticle with respect to the wafer can be determined.

The exposure side metrology uses the measurement side metrology as a baseline and assumes that the measurements are correct. For example, the exposure side will correct exposure side measurements and/or models (e.g., for reticle shape and/or lens aberrations) based on the fiducial surface shape measured on the measurement side.

The skilled person will know that the above description is a simplified overview of a number of very detailed steps involved in one example of a real manufacturing situation. For example rather than measuring alignment in a single pass, often there will be separate phases of coarse and fine measurement, using the same or different marks. The coarse and/or fine alignment measurement steps can be performed before or after the height measurement, or interleaved.

For energy savings, an exposure apparatus such as a lithographic apparatus as described above may have different operating modes such as a sleep, or standby mode (i.e., a low energy mode when the apparatus is not processing substrates) in addition to a default or production mode. After said low energy mode, the apparatus is typically operated in the production mode. Transitioning from a low energy mode to a production mode comprises executing explicit pre-conditioning tasks which can take a relatively long time to complete before substrates can be processed by the apparatus within desired specifications. Pre-conditioning tasks may include, for example, thermal conditioning (e.g., waiting for components such as optical elements to reach a stable operating temperature), resetting timing requirements for control loops (e.g., that have timed-out), calibrating sensors, measuring substrate and/or reticle stage alignment (e.g., moving average updates), updating buffers (and in some cases waiting for thermal stability before filling buffers), and re-establishing models.

Typically, the exposure apparatus will have no throughput until the desired pre-conditioning steps are complete. In some cases, a so-called sacrificial substrate may be processed by the exposure apparatus and subsequently measured to determine if the apparatus is production ready.

It would be desirable to have methods for mitigating the reduced throughput time period of an exposure apparatus such as a lithography apparatus, as experienced during the transition from a low energy mode to a fully operational (or production) mode.

Aspects of the present disclosure provide for an operating mode of an exposure apparatus, for example a lithography apparatus, that may be triggered following a low energy mode of the exposure apparatus (such as sleep mode and/or a standby mode). Such an operating mode (i.e., following a low energy mode and preceding a fully operational mode) may be considered a transition mode and is referred to herein as such. In general terms, the presently disclosed transition mode comprises performing extra measurements, alignment, calibration, control models and the like to compensate for temporarily reduced performance (e.g., owing to system conditions such as thermal stability, status of control loops, sensor calibration and so on, as described with reference to the various pre-conditioning items described above). Achieving overlay and imaging performance within specification as quickly as possible may be prioritized. Advantageously, owing to the presently proposed transition mode, the exposure apparatus may become productive sooner after a low energy mode when compared to a typical pre-conditioning only method as described previously. Furthermore, by virtue of the presently proposed transition mode, modules (i.e., sub-components and/or sub-systems) of the exposure apparatus that typically are not permitted to be in a low energy mode may be put into a low energy mode.

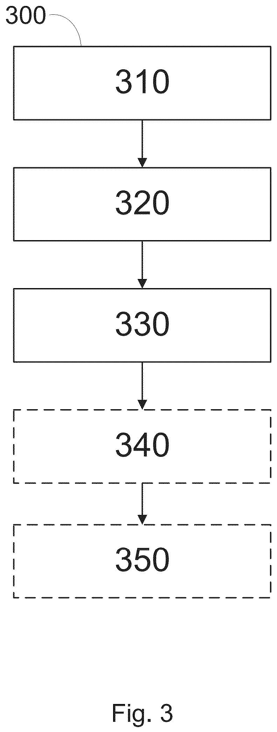

With reference to Figure 3, in a first aspect there is provided a method 300 for operating an exposure apparatus comprising initiating 310 a transition mode responsive to an instruction for the exposure apparatus to transition from a low energy mode to a production mode. Said transition mode comprises measuring 320 at least one operating parameter, and operating 330 the exposure apparatus while performing a compensation procedure based on the at least one operating parameter, wherein the compensation procedure compensates for a reduced performance of the exposure apparatus associated with the low energy mode.

In some examples, the method further comprises monitoring 340 a parameter of interest of the exposure apparatus such as overlay and/or imaging performance and operating the exposure apparatus in the transition mode and determining that the parameter of interest meets a specification threshold (i.e., indicating that the exposure apparatus is no longer operating with reduced performance). When it is determined that the parameter of interest meets the specification threshold, the method may comprise operating 350 the exposure apparatus in the production mode, thus completing the transition from the low energy mode.

The term operating parameter may be understood to mean any specific condition or setting that influences the operation of the apparatus and may comprise any of the following non-limiting examples: a positioning error, a substrate alignment, a substrate stage alignment, a reticle alignment, a reticle stage alignment, an anchoring target measurement, a position encoder measurement, a grid plate drift measurement, a substrate leveling measurement, a plate shape measurement, or a temperature sensor reading. Such operating parameters will be explained further with reference to the various examples described below.

Examples of compensation procedures that may be performed by an exposure apparatus may include any of reticle and/or substrate alignment, stage alignment, re-training of models based on the measured operating parameter, applying optical corrections during an exposure and the like, in order to bring overlay and/or imaging performance into desired specifications. In more general terms, a compensation procedure may be considered a calibration step of the exposure apparatus.

During a typical production mode, an exposure apparatus may be configured to measure so-called anchor targets on a substrate. Anchor targets are metrology targets on a wafer that are measured in between operations such as alignment measurements or alignment to determine any system drift (i.e., a deviation from a defined baseline measurement that may have been caused by said operations). Anchor targets are typically measured once (e.g., after stage alignment) before a substrate is exposed, and system corrections may be calculated based on any drift determined from the anchor target measurements. Accordingly, in some examples, the presently proposed method may comprise performing additional measurements of anchor targets on a substrate immediately after an exposure system transitions out of a low energy mode. This allows system drift caused by the system not being fully conditioned (e.g., not yet thermally conditioned) to be corrected for, which in turn allows the exposure apparatus to be productive sooner than waiting for pre-conditioning tasks to be completed.

Referring again to Figure 1, patterning device MA and substrate W may be aligned prior to an exposure using e.g., mask alignment marks M1, M2 and substrate alignment marks P1, P2. In accordance with the presently proposed method, additional measurements of mask alignment marks and/or substrate alignment marks (e.g., mask alignment marks M1, M2 and/or substrate alignment marks P1, P2) may be acquired immediately after an exposure apparatus transitions out of a low energy mode and/or during substrate processing (i.e., an exposure) during the presently proposed transition mode.

Some exposure apparatus' comprise encoder measurement systems for high-accuracy positioning of sub-components such as substrate stages (e.g., supports WTa and WTb) and/or reticle stage (e.g., mask table MT). Encoder measurement systems use sensor heads that measure a reference grid or grating disposed on a so-called grid plate. Errors on the grid plate (e.g., caused by temperature fluctuations in the measurement environment) may lead to encoder sensor measurement inconsistencies, i.e., multiple encoder sensors provide conflicting position data, resulting in positioning errors. Encoders are calibrated using an encoder measurement sensor inconsistency (EMSI) procedure. For an exemplary system comprising four encoders (e.g., disposed at four corners of a substrate chuck), the EMSI procedure typically involves using a reference area on the gride plate to determine the inconsistency of one encoder relative to the other three.

Typically, when an exposure apparatus is of a so-called dual stage type comprising two substrate stages (e.g., substrate tables WTa, WTb of Figure 1) and two stations, i.e., an exposure station and a measurement station, the EMSI and calibration of encoders is performed at the measurement station. In accordance with the presently proposed method, additional EMSI procedures may be performed at an exposure station of the exposure apparatus to determine and correct for encoder drift and/or gride plate drifts. For example, calibrated measurement station encoder positions may be obtained from a first plurality of encoder position measurements at a measurement station, and calibrated exposure station encoder positions may be obtained from a second plurality of encoder position measurements at an exposure station. An expose-to-measure station offset may be determined based on the calibrated measurement station encoder positions and the calibrated exposure station encoder positions. The determined offset may correspond to grid plate errors (i.e., a drift) that may subsequently be compensated for.

In some examples, additional measurements such as stage alignment and/or reticle alignment measurements may be performed to determine and/or predict alignment drift.

In yet another example, an exposure apparatus may use a level sensor to determine the height of a substrate. Typically, a level sensor spans the width of a substrate and one measurement per exposure field on the substrate is determined. In accordance with the presently proposed method, additional level sensor measurements across the whole width of a substrate may be determined to provide additional height information. Said additional height information may be used to determine and/or predict, and subsequently correct for, vertical drifts and/or drift rates. In some examples, overlapping level measurements of regions on a substrate may be used to determine and correct said drifts between the overlapping measurements.

In some exposure apparatus, shift-between-orders (SBO) calibration can be utilized to correct alignment errors (e.g., such as those that are wavelength and/or order specific) between a fixed alignment mark and a variable alignment mark. SBO refers to a difference in measured position that arises when: (1) different diffraction orders are measured; (2) different wavelengths are measured for the same diffraction order; or (3) different wavelengths are measured for different diffraction orders. SBO calibration with diffraction gratings has been previously described in U.S. Pat. No. 7,112,813, which is hereby incorporated by reference in its entirety. SBO calibration is typically performed once on each substrate stage at the beginning of a substrate lot. In accordance with the presently proposed method, SBO calibration may be performed per-substrate (rather than per-lot). Similarly, plate shape measurements (PSMs), i.e., measurement of the shape of a fiducial plate disposed on a substrate table to determine deformation, may be increased from once per-lot-per-substrate-table to every substrate.

In some examples, the proposed method may comprise repeating reticle alignment measurements prior to exposing a substrate, and determining stage position measurement (SPM) drift from the measurements. For example, reticle stage encoder drift may result in a translation drift between a wafer stage and reticle stage position alignment. Measuring reticle alignment marks and/or reticle stage fiducial marks over time allows for determining, modelling and/or predicting SPM drift rates. A predictive model may be obtained using the determined SPM drift that may be used during subsequent exposures to correct for said drift. The obtained predictive model may be updated based on further reticle alignment measurements. In some examples, reticle alignment measurements may be determined after each exposure. Patterning devices such as reticles typically comprise a patterned side and a substrate side (opposite to the patterned side), which may be understood as a top side and bottom side respectively. During a typical operation mode, the top side and the bottom side are measured once for each substrate. Determining, modelling and/or predicting SPM drift rates in accordance with the presently disclosed transition mode may be achieved using measurement from only the top side or bottom side of the reticle.

In some examples, a reticle stage fiducial mark may be measured preferentially over a reticle alignment mark to prevent cross-talk with reticle heating (as may be present in measurements of reticle alignment mark measurements). In such an example, said reticle stage fiducial marks may be measured before and after top side and bottom side reticle scans, and optionally, additional reticle stage fiducial mark measurements after an exposure.

Some exposure apparatus may comprise a transmission image sensor and/or an interferometer based sensor for measuring alignment targets (e.g., fiducial markers) disposed on a substrate stage e.g., for reticle alignment at an exposure station and/or stage alignment at a measurement station (i.e., of a dual-stage type apparatus), as described previously with reference to Figure 2. These sensor types are not typically used in conjunction with one another. In some examples, the proposed method may comprise obtaining a first measurement of a first alignment target (e.g., transmission image sensor measurement) and a second measurement of a second alignment target (e.g., interferometer based sensor measurement) to obtain dense measurement data (i.e., relatively denser compared to typical production mode measurement data). Said alignment targets may be disposed at different locations on a substrate stage (e.g., opposite sides or corners), advantageously providing a more accurate representation of system state (for example position specific errors) and drifts and allowing for a more complete correction of stage positioning (e.g., encoder mismatch).

In some examples, a plurality of reticle alignment scans (i.e., measurements of reticle alignment) and subsequent reticle alignment may be performed in between the exposure of fields (or a subset of fields) during a substrate exposure. Reticle alignment is typically performed only once at the start of an image exposure rather than between the exposure of fields of the same image. In some examples, the method may further comprise determining a pattern layout dependent effect of the between exposure field (or exposure field subset) reticle alignment, and determining a calibration for the exposure apparatus (i.e., a further compensation procedure) based on the pattern layout dependent effect (i.e., to mitigate said effect).

In any or all examples, additional measurements, drift predictions and the like may be monitored to determine when the apparatus has stabilized (i.e., fully transitioned from a low energy mode) and can be switched to a production mode, for example by comparing said additional measurements, drift predictions and the like to a threshold value that indicates that the apparatus has stabilized. In some examples, additionally or alternatively, a parameter of interest (such as overlay or imaging performance) may be monitored to determine when the exposure apparatus is no longer operating with reduced performance, and can be operated in a production mode.

In any or all examples, additional measurements, drift predictions and the like may be enhanced by including measurements from additional sensors, e.g. temperature sensors, at relevant locations on the apparatus (e.g., grid plates, stages, encoders, alignment/lens reference axis (ARA/LRA), substrate tables and so on). For example, a measured temperature may be associated with a determined position error and/or substrate deformation. This may be achieved by obtaining a model that maps temperature to position error and/or substrate deformation (for example using a physical model or an empirical relation derived through a calibration process). Some temperature sensors (e.g., those disposed on and around substrate tables and the like), are not typically used for single substrate measurements owing to an amount of noise present in measurements. However, such temperature sensors may be suitable for determining a thermal mismatch between a wafer handler and wafer table when measurements are averaged over a substrate lot.

In some examples, the proposed method may comprise operating motorized components such as various stages and/or substrate loading/unloading tools (such as a loading/unloading robot) at lower velocity, acceleration, and jerk (VAJ) values. By lowering VAJ values, less mechanical energy and heat are introduced into the system thus reducing drift associated therewith. Reducing VAJ values also has the effect of improving system dynamic performance which in turn improves overlay and imaging performance, which can be used to offset a reduction in performance owing to drift. Furthermore, motors comprised in stages or substrate loading/unloading tools may have an initial period of operation (i.e., after a low energy mode) where they cannot perform within highest VAJ specifications.

Performing a compensation procedure in accordance with aspects of the present disclosure may introduce unique systematic deviations to the exposure apparatus, a so-called fingerprint. Aspects of the present disclosure further provide for determining a system fingerprint caused by the additional measurements and determining a correction based on the system fingerprint. In some examples, determining said system fingerprint may comprise performing at least one compensation procedure (i.e., in accordance with aspects described previously) to obtain at least one compensated operating parameter value, and determining a deviation of the least one compensated operating parameter value from an expected operating parameter value, wherein the expected operating parameter value corresponds to an operating parameter value expected during a production mode (i.e., normal operating mode) of the apparatus. A model may be obtained based on the determined deviation to interpolate for different compensation procedures with different variations of, for example, fields and mark layouts on a substrate. Features such as metrology targets in resist can be measured (e.g., using scatterometry or reflectometry) before any developing or other processing step directly after being exposed in an exposure apparatus, which is understood as latent image metrology (the latent image referring to the undeveloped but exposed feature). The measuring of features such as latent metrology targets may be used for calibration purposes, saving process time that would otherwise be used for developing. Latent metrology targets can provide information on positioning errors in addition to other key performance indicators that are sensitive to variations in critical dimension (CD).

In accordance with aspects of the present disclosure, the measuring of an operating parameter may comprise exposing a first portion of a substrate (e.g., an exposure field) at an expose station of an exposure apparatus to obtain at least one latent image. The latent image may comprise a latent metrology target. The at least one latent image may be measured, e.g., at a measure station of the exposure apparatus, to determine a positioning error of the latent image, and at least one second portion of the substrate may be exposed based on the positioning error. For example, it may be determined that the latent image is offset from a desired location on a substrate (i.e., the positioning error). Accordingly, corrections may be determined and applied by the exposure apparatus when exposing subsequent portions of the substrate to correct for the positioning error.

Typically, when a substrate is moved to a measure station, stage alignment and encoder zeroing are performed prior to measuring metrology marks. In order to keep the substrate under encoder control (or more specifically, a substrate support upon which the substrate is disposed), the at least one latent image may be measured prior to performing stage alignment and encoder zeroing at the measurement station.

While specific embodiments of the invention have been described above, it will be appreciated that the invention may be practiced otherwise than as described.

Although specific reference may be made in this text to the use of exposure apparatuses, such as lithographic and/or assessment apparatuses used in the process of semiconductor devices, it should be understood that the apparatuses described herein may have other applications. Possible other applications include the process of integrated optical systems, guidance and detection patterns for magnetic domain memories, flat-panel displays, liquid-crystal displays (LCDs), thin film magnetic heads, etc. Embodiments of the invention may be used in other lithographic apparatuses including electron-beam lithographic apparatuses, flat-panel display lithography apparatuses, maskless lithographic apparatuses, (nano)imprint lithographic apparatuses, interference lithography apparatuses, and x-ray lithography apparatus, operable in ambient/ (non-vacuum) and/or in (near)vacuum. Embodiments of the invention may additionally be used in other apparatuses including deposition apparatuses, etching apparatuses, and die-bonding apparatuses.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured. Thus, the lithographic apparatus LA may also be a type of imprint lithographic apparatus, such as a nanoimprint lithographic (NIL) apparatus, which creates patterns by mechanical deformation of imprint resist and subsequent processes. The imprint resist is typically a monomer or polymer formulation that is cured by heat or UV light during the imprinting. Adhesion between the resist and the template may be controlled to allow proper release.

The different aspects of the invention are set out in the following clauses:
1. A method for operating an exposure apparatus comprising:
   initiating a transition mode responsive to an instruction for the exposure apparatus to transition from a low energy mode to a production mode, the transition mode comprising;
   measuring at least one operating parameter; and
   operating the exposure apparatus while performing a compensation procedure based on the at least one operating parameter, wherein the compensation procedure compensates for a reduced performance of the exposure apparatus associated with the low energy mode.
2. The method of clause 1, further comprising;
   monitoring a parameter of interest of the exposure apparatus; and
   operating the exposure apparatus in the transition mode until the parameter of interest meets a specification threshold.
3. The method of clause 2, further comprising;
   determining that the parameter of interest meets the specification threshold; and
   operating the exposure apparatus in the production mode.
4. The method of clause 2 or clause 3, wherein the parameter of interest is any of overlay or imaging performance.
*5.* The method of any preceding clause, further comprising determining a systematic deviation associated with the compensation procedure;
   determining a correction for the systematic deviation; and
   applying the correction to the exposure apparatus.
6. The method of any preceding clause, further comprising reducing velocity, acceleration and jerk, VAJ, values of motorized components comprised in the exposure apparatus when in the transition mode.
7. The method of clause 6, wherein the motorized components comprise any of a substrate stage, a reticle stage, or a substrate loader.
8. The method of any preceding clause, further comprising:
   obtaining a plurality of measurements of the operating parameter; and
   obtaining a predictive model based on the plurality of measurements, wherein the predictive model is configured to predict how the operating parameter drifts over time.
9. The method of clause 8, wherein the compensation procedure is based on the predictive model.
10. The method of clause 8 or clause 9, further comprising obtaining the model based on an additional operating parameter, wherein the additional operating parameter is a temperature sensor reading.
11. The method of any preceding clause, wherein the operating parameter comprises any of: a positioning error, a substrate alignment, a substrate stage alignment, a reticle alignment, a reticle stage alignment, an anchoring target measurement, a position encoder measurement, a grid plate drift measurement, a substrate leveling measurement, a plate shape measurement, or a temperature sensor reading.
12. The method of clause 11, further comprising:
   measuring a plurality of encoders at a measurement station of the exposure apparatus to determine a first plurality of position encoder measurements;
   calibrating the plurality of encoders based on the first plurality of position encoder measurements to obtain calibrated measurement station encoder positions;
   measuring the plurality of encoders at an exposure station of the exposure apparatus to determine a second plurality of position encoder measurements;
   calibrating the plurality of encoders based on the second plurality of position encoder measurements to obtain calibrated measure station encoder positions; and
   determining an expose-to-measure station offset based on the calibrated exposure station encoder positions and the calibrated measure station encoder positions.
13. The method of clause 11 or clause 12, wherein measuring at least one operating parameter comprises measuring the reticle alignment per exposure field and/or subset of exposure fields of an image when exposing a substrate; wherein
   the compensation procedure comprises aligning the reticle per exposure field and/or subset of exposure fields.
14. The method of clause 13, further comprising determining a pattern layout dependent effect of aligning the reticle per exposure field and/or subset of exposure fields, and calibrating the exposure apparatus based on the patter layout dependent effect.
*15.* The method of any of clauses 11 to 14, wherein measuring at least one operating parameter comprises;
   obtaining a first measurement of a first reticle alignment target located at a first location on a substrate stage; and
   obtaining a second measurement of a second reticle alignment target located at a second location on the substrate stage, different from the first;
   wherein the compensation procedure comprises correcting the substrate stage alignment based on the first measurement and the second measurement.
16. The method of clause 15, wherein the first measurement is an interferometry based measurement, and the second measurement is a transmission image sensor measurement.
17. The method of any of clauses 11 to 16, wherein the measuring at least one operating parameter comprises:
   exposing a first portion of a substrate to obtain at least one latent image; and
   measuring the at least one latent image to determine the positioning error;
   wherein the compensation procedure comprises exposing at least one second portion of the substrate based on the positioning error.
18. The method of clause 17, further comprising measuring the at least one latent image before performing stage alignment and/or encoder zeroing at a measurement station of the exposure apparatus.
19. The method of clause 17 or clause 18, wherein the latent image is a latent metrology target.
20. A computer program comprising program instructions operable to perform the method of any of clauses 1 to 19, when run on a suitable apparatus.
21. A non-transient computer program carrier the computer program of clause 20.
22. A processing apparatus comprising:
   at least one processor; and
   the non-transient computer program carrier of clause 21.
23. An exposure apparatus comprising the processing apparatus of clause 22.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

## Claims

1. A method for operating an exposure apparatus comprising:
initiating a transition mode responsive to an instruction for the exposure apparatus to transition from a low energy mode to a production mode, the transition mode comprising;
measuring at least one operating parameter; and
operating the exposure apparatus while performing a compensation procedure based on the at least one operating parameter, wherein the compensation procedure compensates for a reduced performance of the exposure apparatus associated with the low energy mode.

2. The method of claim 1, further comprising;
monitoring a parameter of interest of the exposure apparatus; and
operating the exposure apparatus in the transition mode until the parameter of interest meets a specification threshold.

3. The method of claim 2, further comprising;
determining that the parameter of interest meets the specification threshold; and
operating the exposure apparatus in the production mode.

4. The method of claim 2 or claim 3, wherein the parameter of interest is any of overlay or imaging performance.

5. The method of any preceding claim, further comprising determining a systematic deviation associated with the compensation procedure;
determining a correction for the systematic deviation; and
applying the correction to the exposure apparatus.

6. The method of any preceding claim, further comprising reducing velocity, acceleration and jerk, VAJ, values of motorized components comprised in the exposure apparatus when in the transition mode.

7. The method of claim 6, wherein the motorized components comprise any of a substrate stage, a reticle stage, or a substrate loader.

8. The method of any preceding claim, further comprising:
obtaining a plurality of measurements of the operating parameter; and
obtaining a predictive model based on the plurality of measurements, wherein the predictive model is configured to predict how the operating parameter drifts over time.

9. The method of any preceding claim, wherein the operating parameter comprises any of: a positioning error, a substrate alignment, a substrate stage alignment, a reticle alignment, a reticle stage alignment, an anchoring target measurement, a position encoder measurement, a grid plate drift measurement, a substrate leveling measurement, a plate shape measurement, or a temperature sensor reading.

10. The method of claim 9, further comprising:
measuring a plurality of encoders at a measurement station of the exposure apparatus to determine a first plurality of position encoder measurements;
calibrating the plurality of encoders based on the first plurality of position encoder measurements to obtain calibrated measurement station encoder positions;
measuring the plurality of encoders at an exposure station of the exposure apparatus to determine a second plurality of position encoder measurements;
calibrating the plurality of encoders based on the second plurality of position encoder measurements to obtain calibrated measure station encoder positions; and
determining an expose-to-measure station offset based on the calibrated exposure station encoder positions and the calibrated measure station encoder positions.

11. The method of any of claims 9 to 10, wherein measuring at least one operating parameter comprises;
obtaining a first measurement of a first reticle alignment target located at a first location on a substrate stage; and
obtaining a second measurement of a second reticle alignment target located at a second location on the substrate stage, different from the first;
wherein the compensation procedure comprises correcting the substrate stage alignment based on the first measurement and the second measurement.

12. The method of claim 11, wherein the first measurement is an interferometry based measurement, and the second measurement is a transmission image sensor measurement.

13. The method of any of claims 9 to 12, wherein the measuring at least one operating parameter comprises:
exposing a first portion of a substrate to obtain at least one latent image; and
measuring the at least one latent image to determine the positioning error;
wherein the compensation procedure comprises exposing at least one second portion of the substrate based on the positioning error.

14. The method of claim 13, further comprising measuring the at least one latent image before performing stage alignment and/or encoder zeroing at a measurement station of the exposure apparatus.

15. An exposure apparatus performing one of the methods of claim 1 to 14.
